# EUROPÄISCHE PATENTSCHRIFT

(11) **EP 2 411 558 B1**
(45) Veröffentlichungstag und Bekanntmachung des Hinweises auf die Patenterteilung: **20.11.2013**
(21) Anmeldenummer: 10716273.7
(22) Anmeldetag: 23.03.2010
(51) Int. Cl.: C23C 18/12, H01L 21/368, H01L 31/18

(54) **VERFAHREN ZUM AUFBRINGEN EINER Zn(S, O)-PUFFERSCHICHT AUF EIN HALBLEITERSUBSTRAT MITTELS CHEMISCHER BADABSCHEIDUNG**
METHOD FOR APPLYING A ZN(S, O) BUFFER LAYER TO A SEMICONDUCTOR SUBSTRATE BY CHEMICAL BATH DEPOSITION
PROCÉDÉ POUR APPLIQUER UNE COUCHE TAMPON DE ZN(S, O) SUR UN SUBSTRAT SEMI-CONDUCTEUR PAR DÉPÔT PAR BAIN CHIMIQUE

(30) Priorität: 26.03.2009 DE 102009015063
(43) Veröffentlichungstag der Anmeldung: 01.02.2012
(73) Patentinhaber: Helmholtz-Zentrum Berlin für Materialien und Energie GmbH, 14109 Berlin (DE)
(72) Erfinder: ENNAOUI, Ahmed, 13469 Berlin (DE); SÁEC-ARAOZ, Rodrigo, 10435 Berlin (DE); FLORIAN, Timo, 12207 Berlin (DE); LUX-STEINER, Martha Christina, 14163 Berlin (DE)
(86) Internationale Anmeldenummer: PCT/DE2010/000321
(87) Internationale Veröffentlichungsnummer: WO 2010/108480

(56) Entgegenhaltungen:
- WO-A1-2006/018013
- ORTEGA-LOPEZ M ET AL: "Improved efficiency of the chemical bath deposition method during growth of ZnO thin films" MATERIALS RESEARCH BULLETIN, ELSEVIER, KIDLINGTON, GB LNKD- DOI:10.1016/S0025-5408(03)00083-7, Bd. 38, Nr. 7, 19. Juni 2003 (2003-06-19), Seiten 1241-1248, XP004435136 ISSN: 0025-5408

## Beschreibung

Die Erfindung betrifft ein Verfahren zum Aufbringen einer Zn(S, O)-Pufferschicht auf ein Halbleitersubstrat mittels chemischer Badabscheidung, insbesondere auf die Absorberschicht einer Chalkopyrit-Dünnschicht-Solarzelle, mindestens aufweisend die Verfahrensschritte Herstellen einer chemischen Badlösung unter Zugabe eines Additivs in geringer Konzentration und Tauchen des Halbleitersubstrats in diese Badlösung.

Das chemische Badabscheideverfahren lässt sich beispielsweise auch für die Herstellung von II-VI "superstrat" Dünnschicht-Solarzellen und Chalkopyrit "superstrat" Dünnschicht-Solarzellen anwenden.

In den letzten Jahren werden große Anstrengungen zur Entwicklung kostengünstiger Solarzellen gemacht. Dabei stellen Chalkopyrit-Dünnschicht-Solarzellen den jüngsten Entwicklungsstand dar. Hierbei werden Schichten aus Kupfer und Indium auf ein Substrat aufbracht. Wahlweise kann auch Gallium hinzugefügt werden. Dieses wird dann mit Selen und/oder Schwefel umgesetzt (CIS, CIGS oder CIGSSe, allgemein "CIS-Solarzellen"). Unter den Dünnschicht-Technologien ist die CIS-Technologie wegen ihrer Umweltverträglichkeit und ihrer niedrigen Kosten besonders interessant.

Die Solarzellen werden hergestellt, indem zunächst eine elektrisch leitende Schicht, in der Regel eine aufgesputterte Molybdänschicht, auf Floatglas oder Sodalimglas und nachfolgend CIS, CIGS oder CIGSSe üblicherweise im Hochvakuum von weniger als 3 µm Dicke aufgebracht wird. Auf diese Absorberschicht wird üblicherweise eine Pufferschicht aus Cadmiumsulfid aufgebracht. Als Deckschicht wird wiederum eine transparente und leitfähige Schicht aufgebracht, die so genannte Fensterschicht. Für die Erzeugung von Modulen wird der Absorber auf strukturiertes Glas-Molybdänsubstrat aufgebracht und ebenfalls nach der Aufbringung der Pufferschicht strukturiert, so dass eine elektrische Verschaltung entsteht. Durch Kontaktierung und Rahmung der gesamten Struktur entsteht ein Dünnschicht-Solarmodul, das zur Umwandlung von Lichtenergie in elektrische Leistung dient.

Es sind wegen der Nachteile von Glas als Substrat auch verschiedene Anstrengungen unternommen worden, um statt Glas flexible Materialien einsetzen zu können. So sind auch Solarmodule bekannt, bei denen als Substrat ein metallisches Band verwendet wird. Ebenfalls bekannt geworden sind Kunststoff-Folien zur CIS-Abscheidung. Angeregt wurde auch bereits ein elektrolytisches Aufbringen der CIS-Schicht.

Damit aber eine solche Dünnschicht-Solarzelle effizient arbeiten kann, benötigt man eine Pufferschicht zwischen der Absorber-Schicht (z.B. Cu(InₐGa_{b})(SₓSe_{y})) und der Fensterschicht(i-ZnO/ZnO:Ga). Diese schützt die Oberfläche vor Beschädigungen, die beim Auftragen der Fensterschicht entstehen können. Des Weiteren sorgt sie für eine Oberflächendotierung der Absorber-Schicht, sowie eine Passivierung der Oberfläche um niedrigere Oberflächenzustände zu erhalten. Um diese sehr dünne Pufferschicht auftragen zu können, kommen die drei üblichen Verfahren Sputtern, Aufdampfen oder (elektro)chemische Abscheidung in Frage. Sputtern oder Aufdampfen verlangen beide einen hohen apparativen Aufwand. Am günstigsten erweist sich bisher die chemische Badabscheidung (Chemical Bath Deposition - CBD).

In DE 10 2004 040 546 B3 wird ein Verfahren zum Aufbringen einer Zinksulfid-Pufferschicht auf ein Halbleitersubstrat beschrieben, das ohne giftige oder umweltgefährdende Zusätze auskommt und einen vergleichbaren bzw. günstigeren apparativen und zeitlichen Aufwand hat als bisherige Verfahren zum Aufbringen von Cadmiumsulfid. Bei dem dort vorgestellten Verfahren werden zunächst 0,05 bis 0,5 mol/l Zinksulfat und 0,2 bis 1,5 mol/l Thioharnstoff in destilliertem Wasser bei einer Temperatur zwischen 70 °C und 90 °C aufgelöst. Nach vollständigem Auflösen von Zinksulfat und Thioharnstoff in destilliertem Wasser erfolgt nun die anschließende Zugabe von ca. 25 %-igem Ammoniak in Höhe eines Drittels der Wassermenge. Erst wenn auch diese Lösung klar ist, wird das Halbleitersubstrat für etwa 10 Minuten in die Lösung getaucht, wobei deren erreichte Temperatur in dieser Zeit im Wesentlichen konstant gehalten wird.

In Thin Solid Films 517 (2009) 2300-2304 wird eine mittels CBD auf CIS- und CIGSS-Absorbermaterialien aufgewachsene ZnS/Zn(S, O)-Pufferschicht untersucht. Das dort zitierte CBD-Verfahren ist in der genannten DE 10 2004 040 546 B3 beschrieben und wird mit verschiedenen Konzentrationen von NH₃ ausgeführt. Die Schichtbildung wird beobachtet und charakterisiert mittels Transmissionsmessung der Badlösung, wobei die Trübung der Lösung eine Aussage über Bedingungen für die Reproduzierbarkeit der Schichtaufbringung liefert.

In Materials Research Bulletin 38 (2003) 1241-1248 wird ein CBD-Verfahren zum Aufbringen eines dünnen ZnO-Films beschrieben, bei dem durch die Zugabe von H₂O₂ in die Badlösung, die keinen Thioharnstoff enthält, die Entstehung der unlöslichen Phase von Zinkperoxid bewirkt bzw. verstärkt und die unerwünschte Reaktion an der Reaktorwand minimiert wird. Zur Bildung einer ZnO-Schicht muss das unter Vorhandensein von H₂O₂ gebildete ZnO₂ einer Temperbehandlung über 2 h bei 350 °C unterzogen werden.

In den Proceedings zur 23rd European Photovoltaic Solar Energy Conference, 1-5 September 2008, Valencia, Spain, 2133-2136 wird über ein modifiziertes Verfahren der chemischen Badabscheidung für Zn(S, O)-Pufferschichten berichtet, bei dem der Badlösung, wie sie in DE 10 2004 040 546 B3 für die Herstellung von ZnS-Pufferschichten beschrieben wurde, ein Additiv in geringer Konzentration zugegeben wird. Durch Zugabe eines Additivs konnte die Abscheiderate für Substrate mit größerer Fläche wesentlich erhöht werden. Nähere Angaben zu diesem Additiv sind der Veröffentlichung nicht zu entnehmen.

Aufgabe der Erfindung ist es deshalb, für das o. g. modifizierte CBD-Verfahren ein Additiv in seiner chemischen Zusammensetzung zu benennen, unter dessen Hinzufügung die Abscheiderate für eine Zn(S, O) enthaltende Pufferschicht erhöht wird und diese eine homogene Schichtzusammensetzung, d. h. eine gleichmäßige Verteilung von Sauerstoff und Schwefel, aufweist. Gleichzeitig soll der Wirkungsgrad einer Solarzelle, die eine mit dem erfindungsgemäßen Verfahren hergestellte Pufferschicht aufweist, vergleichbar sein mit dem für Solarzellen, hergestellt mit bekannten CBD-Verfahren.

Die erfindungsgemäße Lösung für diese Aufgabe ist dem Hauptanspruch zu entnehmen. Vorteilhafte Modifikationen des erfindungsgemäßen Verfahrens sind den Unteransprüchen zu entnehmen, die im Folgenden im Zusammenhang mit der Erfindung im Einzelnen näher erläutert werden.

Das erfindungsgemäße Verfahren ist gekennzeichnet durch die folgenden Verfahrensschritte: Zugabe von 0,05 bis 0,5 mol/l Zinksalz und von 0,2 bis 1,5 mol/l Thioharnstoff in destilliertes Wasser bei einer Temperatur zwischen 70 °C und 90 °C, nach vollständiger Auflösung von Zinksalz und Thioharnstoff in destilliertem Wasser wird anschließend ca. 25 %-iger Ammoniak in Höhe eines Drittels der Wassermenge zugegeben, anschließend wird - nachdem sich das durch Zugabe von Ammoniak gebildete Zinkhydroxid vollständig in der chemischen Badlösung aufgelöst hat - dem Bad als Additiv Wasserstoffperoxid von bis zu 5% der Badlösung zugegeben und nach Klarwerden der Lösung das Halbleitersubstrat bis zu 10 Minuten in die Lösung getaucht, wobei deren erreichte Temperatur in dieser Zeit im Wesentlichen konstant gehalten wird.

Auch bei der Weiterbildung des bekannten CBD-Verfahrens ist es von besonderer Bedeutung, dass erst nach vollständigem Auflösen der eingebrachten Badbestandteile in der Lösung die weiteren Bestandteile einzeln zugegeben werden, denn es war ja festgestellt worden, dass sich allein durch eine andere Reihenfolge der Reaktionen zwischen den drei beteiligten Stoffen Zinksulfat, Thioharnstoff und Ammoniak und bestimmte Prozessbedingungen ein völlig geändertes Abscheideverhalten von Zinksulfid ergibt, indem im Unterschied zu dem von Nakada et al. angegebenen Verfahren (s. "Polycristalline (Cu(In,Ga)Se2 Thin Film Solar Cells with Chemically Deposited Sulfide (CdS,ZnS) Buffer Layers", 2nd World Conference and Exhibition on Photovoltaic Solar Energy Conversion, 6-10 July 1998, Wien) erst die Zinkionen mit dem Thioharnstoff reagieren (komplexiert werden) und erst danach die Zugabe von Ammoniak erfolgt, welches dann mit den verbleibenden Zinkionen ebenfalls reagiert (komplexiert). Thioharnstoff wirkt hierbei nun als Komplexierungsmittel und als Quelle der Sulfidionen.

H₂O₂ ist dem Fachmann als Oxidationsmittel wohl bekannt, jedoch hat sich bei Versuchen zum Aufbringen von ZnO-Nanorods überraschend herausgestellt, dass H₂O₂ eine beschleunigende Wirkung bezüglich der Abscheidung von Zn(S, O) aufweist ohne dass die Oxidationsstufe von Zn²⁺ dabei verändert wird.

Im Ergebnis des erfindungsgemäßen Verfahrens bildet sich eine gleichmäßig dicke Schicht aus Zn(S, O) auf dem Halbleitersubstrat aus, deren Zusammensetzung im Vergleich zur Abscheidung der ohne Wasserstoffperoxid erzeugten Pufferschicht auch homogener bezüglich der Verteilung von Sauerstoff und Schwefel in dieser ist. Es wurde festgestellt, dass das Verhältnis von Schwefel und Sauerstoff in der aufgebrachten Pufferschicht abhängig ist von der zugegebenen Menge H₂O₂. Gleichzeitig konnte für großflächige Substrate eine wesentliche Erhöhung der Abscheiderate bei unverändertem Wirkungsgrad im Vergleich zu einer Solarzelle auf einem ca. 0,5 cm² großem Substrat, hergestellt mit dem eingangs erwähnten Verfahren, erreicht werden.

In einer Ausführungsform der Erfindung wird als Zinksalz Zinksulfat oder Zinkacetat oder Zinkchlorid oder Zinknitrat verwendet.

Bevorzugt wird in einer anderen Ausführungsform das zugegebene Wasserstoffperoxid in einer Konzentration von bis zu 1 % in der chemischen Badlösung verwendet.

Auch dieses modifizierte CBD-Verfahren unter Zugabe von H₂O₂ liefert als Nebenprodukt hochwertiges ZnS/ZnO-Pulver, das anderweitig weiter verwendet werden kann. Die Substrate werden zweckmäßig anschließend in einer Ammoniak/Wasser-Lösung gespült und im Stickstoffgasstrom getrocknet. Abschließend erfolgt noch für eine bestimmte Zeit eine Temperung in Luft zwischen 100 °C und 220 °C. Nach dem Aufbringen der Fensterschicht erhält man die fertige Zelle.

Das Verfahren soll nachstehend anhand eines Ausführungsbeispiels näher erläutert werden. Die zugehörigen Figuren zeigen:
- Fig. 1: Messkurven der normierten transmittierten Intensität in Abhängigkeit der Tauchzeit für verschiedene chemische Badlösungen im Vergleich;
- Fig. 2: Messkurven der normierten transmittierten Intensität in Abhängigkeit der Tauchzeit für verschiedene Konzentrationen von H₂O₂ in der Badlösung.

In dem folgenden Ausführungsbeispiel werden die Proben vor dem Aufbringen von Zn(S, O) auf Chalkopyritabsorbern mittels der chemischen Badabscheidung in einer Wasser/Ammoniak-Lösung gereinigt.

Das chemische Bad wird wie folgt hergestellt:
Zunächst wird eine heiße Lösung (50 °C) mit 0,15 mol/l Zinksulfat aus Reinstwasser hergestellt. Bei 70°C wird dann Thioharnstoff (SC(NH₂)₂) unter Rühren hinzugegeben. Nach 3 min und anschließender Zugabe einer NH₃-Lösung entsteht ein weißer Niederschlag, der sich durch fortgesetztes Rühren wieder auflöst. Es entsteht eine völlig klare Lösung mit einem pH-Wert von 10 bis 11. Die Konzentration von Thioharstoff beträgt 0,6 mol/l, die von NH₃ 4mol/l. Jetzt erfolgt die Zugabe von H₂O₂ zu einer Badkonzentration von 0,5 %, die Lösung wird nun gerührt bis sie klar ist.

In diese Badlösung werden die Proben (beispielsweise CulnS₂-Schichten auf einem Substrat) 7 min eingetaucht. Während der Abscheidung wird die Lösung weiter gerührt und die Temperatur weiter gehalten.

Die anfangs klare Lösung beginnt sich nach ca. 90 Sekunden einzutrüben. Nach 7 min werden die Proben entnommen, mit einer Wasser/AmmoniakLösung gewaschen und im Stickstoffstrom getrocknet.

Die Schichtdicke der entstandenen Zn(S, O)-Pufferschicht auf dem Absorber der Proben beträgt ca. 10 bis 20 nm.

Die beschichteten Proben werden nun bei 100 bis 220 °C in Luft getempert.

Die chemische Badlösung aus dem erfindungsgemäßen Verfahren ist mehrmals benutzbar, wenn nach einem Filtrierschritt erneut H₂O₂ zugegeben wird.

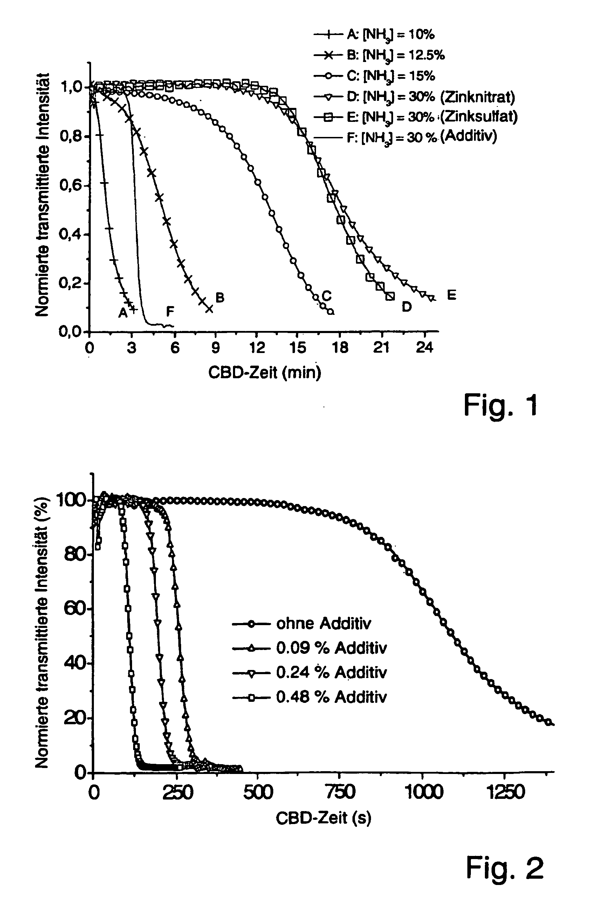

Die Kurven A bis E in der Fig. 1 zeigen die transmittierte Intensität in Abhängigkeit der Eintauchzeit der Proben in die Badlösung für verschiedene dem Stand der Technik nach bekannte Zusammensetzungen der Badlösung. Die Kurve F zeigt das Messergebnis für eine Struktur mit einer Pufferschicht, die mittels erfindungsgemäßem Verfahren, also bei Zugabe von H₂O₂, erzeugt wurde. Gut erkennbar ist die verringerte Zeit zum Aufbringen einer Pufferschicht bei diesem Verfahren.

Fig. 2 zeigt die transmittierte Intensität der Badlösung für verschiedene Konzentrationen von H₂O₂, auch im Vergleich ohne Zugabe von H₂O₂. Es wird deutlich, dass schon geringe Konzentrationen eine deutliche Verringerung der Zeit bei der Erreichung einer klaren Badlösung - und somit eine größere Abscheiderate der Zn(S, O)-Pufferschicht bewirken.

Mittels XPS (X-Ray Photoelectron Spectroscopy) und XAES (X-Ray Excited Auger Electron Spectroscopy) konnte eine homogene Verteilung von Schwefel und Sauerstoff in der abgeschiedenen Zn(S, O)-Pufferschicht nachgewiesen werden. Auch der Wirkungsgrad der mit dem erfindungsgemäßen CBD-Verfahren erzeugten Strukturen war reproduzierbar und lag bei vergleichbaren Werten wie jene mit bekannten CBD-Verfahren hergestellten Zellen.

## Patentansprüche

1. Verfahren zum Aufbringen einer Zn(S, O)-Pufferschicht auf ein Halbleitersubstrat mittels chemischer Badabscheidung, insbesondere auf die Absorberschicht einer Chalkopyrit-Dünnschicht-Solarzelle, mindestens aufweisend die Verfahrensschritte Herstellen einer chemischen Badlösung unter Zugabe eines Additivs in geringer Konzentration und Tauchen des Halbleitersubstrats in diese Badlösung,
**dadurch gekennzeichnet, dass**
- zunächst 0,05 bis 0,5 mol/l Zinksalz und von 0,2 bis 1,5 mol/l Thioharnstoff in destilliertem Wasser bei einer Temperatur zwischen 50 °C und 90 °C aufgelöst werden,
- nach vollständiger Auflösung von Zinksalz und Thioharnstoff in destilliertem Wasser anschließend ca. 25 %-iger Ammoniak in Höhe eines Drittels der Wassermenge zugegeben wird,
- nachdem sich das durch Zugabe von Ammoniak gebildete Zinkhydroxid vollständig in der chemischen Badlösung aufgelöst hat, anschließend dem Bad als Additiv Wasserstoffperoxid in einer Konzentration von bis zu 5 % zugegeben wird und
- nach Klarwerden der Lösung das Halbleitersubstrat bis zu 10 Minuten in die Lösung getaucht wird, deren erreichte Temperatur in dieser Zeit im Wesentlichen konstant gehalten wird.

2. Verfahren nach Anspruch 1,
**dadurch gekennzeichnet, dass**
als Zinksalz Zinksulfat oder Zinkacetat oder Zinkchlorid oder Zinknitrat verwendet wird.

3. Verfahren nach Anspruch 1,
**dadurch gekennzeichnet, dass**
die Konzentration des Wasserstoffperoxid bevorzugt bis 1 % beträgt.

4. Verfahren nach Anspruch 1,
**dadurch gekennzeichnet, dass**
die Lösung fortwährend gerührt wird.

5. Verfahren nach Anspruch 1,
**dadurch gekennzeichnet, dass**
das zuvor in einer Ammoniak/Wasser-Lösung behandelte Halbleitersubstrat nach dem Tauchen mit einer Ammoniak/Wasser-Lösung gespült, mit Stickstoff getrocknet und anschließend bei ca. 100 bis 220 °C getempert wird.

## Claims

1. A method for applying a Zn(S, O) buffer layer to a semiconductor substrate by means of chemical bath deposition, in particular to the absorber layer of a chalcopyrite thin-film solar cell, at least having the following method steps: producing a chemical bath solution with addition of an additive in low concentration and dipping the semiconductor substrate into said bath solution,
**characterised in that**
- initially 0.05 to 0.5 mol/l of zinc salt and from 0.2 to 1.5 mol/l of thiourea are dissolved in distilled water at a temperature between 50 °C and 90 °C,
- after complete dissolution of zinc salt and thiourea in distilled water, approximately 25 % ammonia is then added in an amount of one third of the quantity of water,
- once the zinc hydroxide formed by addition of ammonia has dissolved completely in the chemical bath solution, hydrogen peroxide in a concentration of up to 5 % is then added to the bath as an additive, and
- once the solution has become clear, the semiconductor substrate is dipped for up to 10 minutes in the solution, of which the temperature reached in this time is kept substantially constant.

2. The method according to Claim 1,
**characterised in that**
zinc sulphate or zinc acetate or zinc chloride or zinc nitrate is used as zinc salt.

3. The method according to Claim 1,
**characterised in that**
the concentration of the hydrogen peroxide is preferably up to 1 %.

4. The method according to Claim 1,
**characterised in that**
the solution is stirred continuously.

5. The method according to Claim 1,
**characterised in that**
the semiconductor substrate treated previously in an ammonia/water solution is rinsed, after dipping, with an ammonia/water solution, dried with nitrogen and then tempered at approximately 100 to 220 °C.

## Revendications

1. Procédé pour l'application d'une couche tampon Zn(S, O) sur un substrat de semi-conducteur au moyen d'un dépôt en bain chimique, notamment sur la couche d'absorbeur d'une cellule solaire de chalcopyrite à couche mince, comportant au moins les étapes de procédé de la création d'une solution pour bain chimique en ajoutant un additif en faible concentration et de l'immersion du substrat de semi-conducteur dans ladite solution pour bain, **caractérisé en ce**
- **qu'**on fait dissoudre d'abord de 0,05 à 0,5 moles/l de sel zincique et de 0,2 à 1,5 moles/l de thio-urée dans de l'eau distillée à une température comprise entre 50°C et 90°C,
- après dissolution complète du sel zincique et de la thio-urée dans de l'eau distillée, on ajoute par la suite de l'ammoniac à 25 % à concurrence d'un tiers de la quantité d'eau,
- après dissolution complète de l'hydroxyde de zinc formé par l'addition d'ammoniac dans la solution du bain chimique, on ajoute ensuite en tant qu'additif au bain du peroxyde d'hydrogène dans une concentration de jusqu'à 5 % et
- une fois que la solution est devenue limpide, on immerge le substrat de semi-conducteur pendant jusqu'à 10 minutes dans la solution, dont on maintien sensiblement constante la température atteinte pendant ce temps.

2. Procédé selon la revendication 1,
**caractérisé en ce qu'**
on utilise en tant que sel zincique du sulfate de zinc ou de l'acétate de zinc ou du chlorure de zinc ou du nitrate de zinc.

3. Procédé selon la revendication 1,
**caractérisé en ce que**
la concentration du peroxyde d'hydrogène s'élève de préférence à jusqu'à 1 %.

4. Procédé selon la revendication 1,
**caractérisé en ce qu'**
on agite continuellement la solution.

5. Procédé selon la revendication 1,
**caractérisé en ce qu'**
après immersion, on rince avec une solution ammoniac/eau le substrat de semi-conducteur traité préalablement dans une solution ammoniac/eau, on le sèche à l'azote et on le malléabilise ensuite à environ de 100 à 220 °C.
